# EUROPEAN PATENT APPLICATION

(11) **EP 3 608 804 A1**
(43) Date of publication of application: **12.02.2020**
(21) Application number: 19178428.9
(22) Date of filing: 05.06.2019
(51) Int. Cl.: G06F 17/50, G06F 17/28

(54) **ANALYSIS DEVICE**

(30) Priority: 09.08.2018 JP 2018150751
(71) Applicant: Subaru Corporation, Tokyo 150-8554 (JP)
(72) Inventor: TANAKA, Yuki, Tokyo, 150-8554 (JP); KOBAYASHI, Toshimasa, Tokyo, 150-8554 (JP)
(74) Representative: Sajda, Wolf E.

(57) **Abstract**

An analysis device (1) includes a language analyzer (10) and an output module (11). The language analyzer (10) conducts a natural language analysis on a textual information in a drawing data, for deriving textual requirements indicated by the textual information with reference to a known standard data. The output module (11) outputs the textual requirements analyzed by the language analyzer (10).

## Description

### Cross-Reference to Related Applications

The present application claims priority from Japanese Patent Application No. 2018-150751 filed on August 9, 2018.

### Background

The invention relates to an analysis device that analyzes drawing data.

There has been proposed conventional analysis devices that conducts a natural language analysis on input textual information, and checks a result of the natural language analysis against drawing data (for example, Japanese Unexamined Patent Application Publication JP 2012-38055 A).

### Summary

An aspect of the invention provides an analysis device including: a language analyzer configured to conduct a natural language analysis on a textual information in a drawing data, for deriving textual requirements indicated by the textual information with reference to a known standard data; and an output module configured to output the textual requirements analyzed by the language analyzer.

### Brief Description of the Drawings

The accompanying drawings are included to provide a further understanding of the invention and are incorporated in and constitute a part of this specification. The drawings illustrate example embodiments and, together with the specification, serve to explain the principles of the invention.
- FIG. 1: is a block diagram illustrating a configuration of an analysis device according to the present invention;
- FIG. 2: is a diagram for describing functional blocks of a CPU;
- FIG. 3: is a diagram for describing a program and data that are stored in a storage device;
- FIG. 4: is a diagram for describing three-dimensional CAD data;
- FIG. 5: is a diagram for describing a standard "M-Specl_D-1";
- FIG. 6: is a diagram for describing textual analysis result data;
- FIG. 7: is a diagram for describing images that display a comparison result in a language comparison process;
- FIG. 8: is a diagram for describing images that display a comparison result in a model comparison process; and
- FIG. 9: is a flowchart illustrating a flow of an analysis process.

### Detailed Description

In the following, some embodiments of the invention are described in detail with reference to the accompanying drawings. Note that sizes, materials, specific values, and any other factors illustrated in respective embodiments are illustrative for easier understanding of the invention, and are not intended to limit the scope of the invention unless otherwise specifically stated. Further, elements in the following example embodiments which are not recited in a most-generic independent claim of the invention are optional and may be provided on an as-needed basis.

Throughout the present specification and the drawings, elements having substantially the same function and configuration are denoted with the same reference numerals to avoid any redundant description. Further, elements that are not directly related to the invention are unillustrated in the drawings. The drawings are schematic and are not intended to be drawn to scale.

With regard to image data such as three-dimensional CAD data, sometimes structural requirements are indicated by textual information in a tree structure. The textual information indicates standard numbers or the like stipulated by known standards. In addition, a worker who reads the image data is capable of recognizing actual contents indicated by the textual information with reference to the known standards.

However, it takes a long time to refer to the known standards, and there is a problem of a decrease in working efficiency.

Therefore, it is desirable to provide an analysis device that makes it possible to improve the working efficiency.

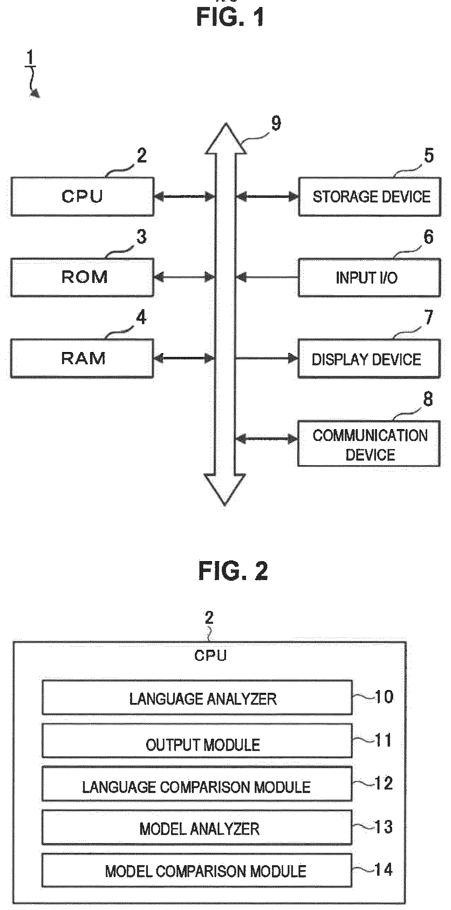

FIG. 1 is a block diagram illustrating a configuration of an analysis device 1. As illustrated in FIG. 1, the analysis device 1 is a computer including a central processing unit (CPU) 2, read only memory (ROM) 3, and random access memory (RAM) 4. The analysis device 1 includes a storage device 5, an input/output interface (input I/O) 6, a display device 7, and a communication device 8.

In the analysis device 1, the CPU 2, the ROM 3, the RAM 4, the storage device 5, the input interface 6, the display device 7, and the communication device 8 are coupled via a bus 9.

The CPU 2 decompresses and executes a program stored in the ROM 3 or the storage device 5, in the RAM 4, and controls the whole analysis device 1.

For example, the storage device 5 is implemented by a hard disk drive (HDD), a solid state drive (SDD), or the like, and stores various kinds of data such as various types of data and programs (software) executable for the CPU 2. Note that, details of the data stored in the storage device 5 will be described later.

For example, the input interface 6 is implemented by a mouse, a keyboard, a touchscreen, or the like, and receives operation input by a user. The input interface 6 outputs information to the CPU 2 in accordance with the operation input by the user.

The display device 7 is implemented by a liquid crystal display, an organic electro-luminescence (EL) display, or the like, and displays images under the control of the CPU 2.

The communication device 8 couples to and communicates with external equipment via a network in a wired or wireless manner, under the control of the CPU2.

FIG. 2 is a diagram for describing functional blocks of the CPU2. The CPU 2 decompresses and executes a program stored in the ROM 3 or the storage device 5, in the RAM 4, and functions as a language analyzer 10, an output module 11, a language comparison module 12, a model analyzer 13, and a model comparison module 14, as illustrated in FIG. 2. Note that, details of the language analyzer 10, the output module 11, the language comparison module 12, the model analyzer 13, and the model comparison module 14 will be described later.

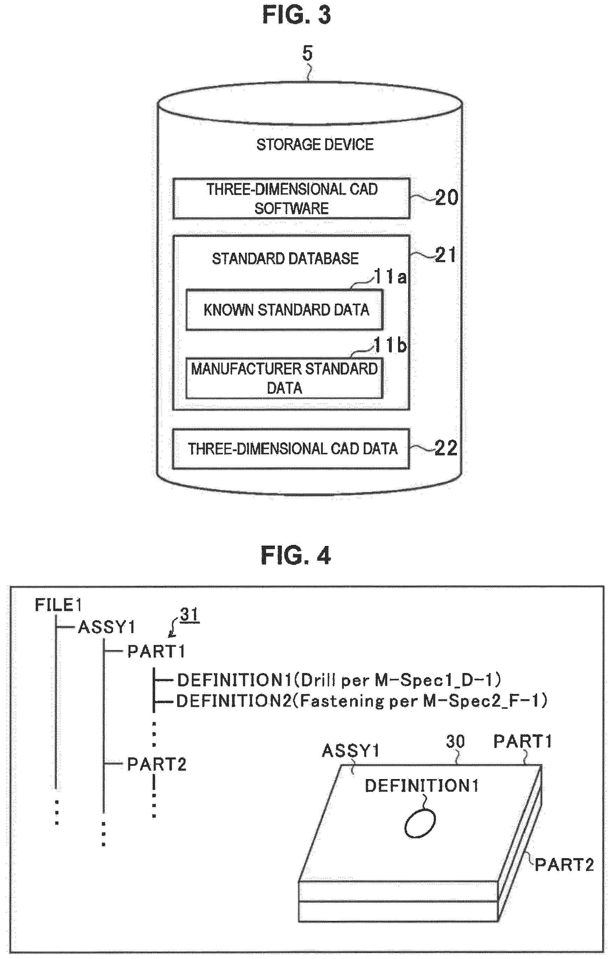

FIG. 3 is a diagram for describing a program and data that are stored in the storage device 5. The storage device 5 stores three-dimensional computer aided design (CAD) software 20, a standard database 21, and three-dimensional CAD data 22. The CPU 2 is capable of executing the three-dimensional CAD by decompressing and executing the three-dimensional CAD software 20 in the RAM 4.

The standard database 21 stores known standard data such as standards in various countries and standards of various companies. For example, the standard database 21 stores known standard data (such as ASME standard data, for example) 11a and standards specific to manufacturers or spec standard data (manufacturer standard data) 11b.

The three-dimensional CAD data 22 may be three-dimensional CAD data generated through the three-dimensional CAD software 20. Note that, the three-dimensional CAD data 22 does not have to be stored in the storage device 5. For example, the analysis device 1 may acquire the three-dimensional CAD data 22 through the communication device 8.

FIG. 4 is a diagram for describing the three-dimensional CAD data 22. Note that, FIG. 4 illustrates a state where the three-dimensional CAD data 22 is read out by the three-dimensional CAD software 20 and displayed on the display device 7.

As illustrated in FIG. 4, the three-dimensional CAD data 22 includes a three-dimensional model 30 and a hierarchical tree structure 31. In the three-dimensional model 30, a shape, a position, a direction, and the like are indicated by lines and dots. The tree structure 31 manages assemblies, parts, and the like included in the three-dimensional model 30 by classifying them into hierarchies. Specifically, in the tree structure 31, a file name of the three-dimensional CAD data 22 is disposed in an uppermost hierarchy.

In addition, in second and subsequent hierarchies in the tree structure 31, the assemblies, parts, drawing requirement items (for example, a process condition item, fastening condition item, and the like) of the three-dimensional model 30 are disposed in one or more hierarchies. In addition, the tree structure 31 includes textual information in the drawing requirement item.

In the example of FIG. 4, assembly "ASSY1", ... (hierarchy 1) is disposed below a hierarchy of the file name "FILE1" (hierarchy 0). In addition, below the hierarchy of the assembly "ASSY1", a part "PARTI", a part "PART2", ... (hierarchy 2) are disposed. In addition, below the hierarchy of the part "PARTI", a drawing requirement item "DEFINITION1", a drawing requirement item "DEFINITION2", ... (hierarchy 3) are disposed. The drawing requirement item "DEFINITION 1" includes textual information "Drill per M-Spec1_D-1" that indicates a diameter of a hole. The drawing requirement item "DEFINITION2" includes textual information "Fastening per M-Spec2_F-1" that indicates a fastening method.

Here, as textual information, the textual information "Drill per M-Spec1_D-1" indicates that a drill process is performed on the basis of a manufacturer standard "M-Spec1_D-1". In addition, as textual information, the textual information "Fastening per M-Spec2_F-1" indicates that fastening is done on the basis of a manufacturer standard "M-Spec2_F-1".

As described above, not only the model requirement for the three-dimensional model 30 but also various kinds of textual requirements including the textual information are attached to the three-dimensional CAD data 22 by using the tree structure 31. For example, the three-dimensional CAD data 22 of an aircraft sometimes includes 500 000 requirements (model requirements and textual requirements) in the tree structure 31.

In addition, with regard to conventional designs, the three-dimensional CAD data 22 is created by a drawing production department. Next, a production technology department and a quality assurance department check the created three-dimensional CAD data 22. Here, all requirements in the tree structure 31 of the three-dimensional CAD data 22 are checked by hand work.

For example, diameters of holes, fastening methods, and the like are checked by checking them against known standards on the basis of the textual information indicated by the drawing requirement items. In addition, the quality assurance department creates quality records with regard to the respective drawing requirement items in the tree structure 31 of the three-dimensional CAD data 22.

Next, the drawing production department corrects the three-dimensional CAD data 22 in the case where the production technology department and the quality assurance department find an error. By repeating the above-described work, it is possible to create the final three-dimensional CAD data 22 and final quality records.

However, the above-described method includes human error such as occurrence of overlapping work or omission of a check or work, and sometimes an error that the workers do not notice occurs. In addition, sometimes a priority changes due to a combination of a requirement defined in the tree structure 31 of the three-dimensional CAD data 22 and a requirement defined in a known standard, or the like.

Therefore, the conventional designs require a huge amount of time for workers to check and correct the three-dimensional CAD data 22 and create quality records.

In addition, when copying the three-dimensional model 30, sometimes dimensional information or the like appears as an error because of a conversion error or the like even in the case where the three-dimensional model 30 is not actually changed. When a worker checks the three-dimensional model 30 in such a case, an error is detected. It is possible to avoid such kinds of errors when the worker changes confirmation intensity (to be described later).

Therefore, the analysis device 1 conducts a natural language analysis on the three-dimensional CAD data 22 and outputs an analysis result of the natural language analysis. Accordingly, it is possible for all the workers to use the analysis result and improve working efficiency. Next, details of an analysis process will be described.

The analysis device 1 performs a natural language process, a language comparison process, and a model comparison process. In the natural language process, a natural language analysis is conducted on textual information included in the tree structure 31. In the language comparison process, analysis results of the tree structures 31 of two pieces of the three-dimensional CAD data 22 are compared. In the model comparison process, the three-dimensional models 30 in the two pieces of the three-dimensional CAD data 22 are compared.

When a worker selects any of the language analysis process, the language comparison process, and the model comparison process via the input interface 6, the analysis device 1 executes the selected process.

### Language analysis process

When the language analysis process is selected and the three-dimensional CAD data 22 that is a target of the process is selected via the input interface 6, the language analyzer 10 decompresses the selected three-dimensional CAD data 22 in the RAM 4 via the three-dimensional CAD software 20. Accordingly, the language analyzer 10 becomes capable of analyzing the three-dimensional CAD data 22.

Next, when the three-dimensional CAD data 22 that is the target of the process is decompressed in the RAM 4, the language analyzer 10 analyzes the three-dimensional model 30 and the tree structure 31. Specifically, the language analyzer 10 extracts textual information from respective items included in the tree structure 31. Next, the language analyzer 10 conducts a natural language analysis on the extracted textual information.

For example, the language analyzer 10 extracts textual information "Drill per M-Spec1_D-1". Next, the language analyzer 10 determines whether the extracted textual information "Drill per M-Spec1_D-1" includes textual information (character string) that is consistent with standard data stored in the standard database 21.

For example, it is assumed that a standard "M-Specl_D-1" is stored in the manufacturer standard data 11b. In this case, the language analyzer 10 determines that a character string "M-Specl_D-1" in the textual information "Drill per M-Spec1_D-1" is consistent with the standard data.

In this case, the language analyzer 10 reads out a standard "M-Specl_D-1" from the manufacturer standard data 11b. Next, the language analyzer 10 refers to the standard "M-Specl_D-1" and derives a diameter of a hole corresponding to the textual information "Drill per M-Spec1_D-1".

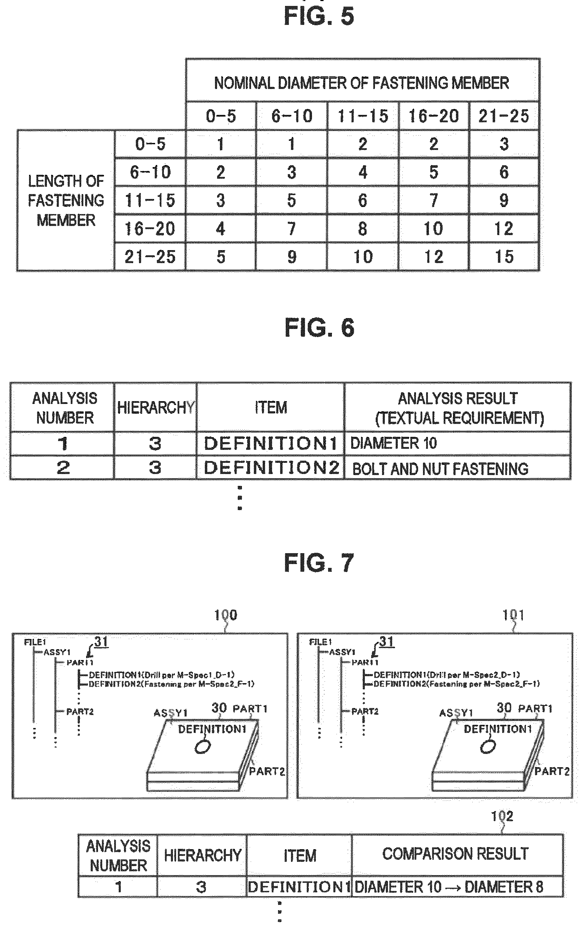

The language analyzer 10 derives requirements in the standard from conditions in the drawings. For example, FIG. 5 is a diagram for describing the standard "M-Spec1_D-1". As illustrated in FIG. 5, in the standard "M-Spec1_D-1", diameters of holes are associated with nominal diameters and lengths of fastening parts such as a bolt, a screw, and a fastener.

Accordingly, the language analyzer 10 analyzes a direction of a hole, and a thickness and a position of a part to which the textual information "Drill per M-Spec1_D-1" is applied, on the basis of the three-dimensional model 30 of the part "PARTI" and the assembly "ASSY1" that is in a higher hierarchy than the textual information "Drill per M-Spec1 D-1".

Next, on the basis of the analyzed thickness of the part, the language analyzer 10 derives the diameter of the hole (textual requirement) with reference to the read-out standard "M-Spec1_D-1". In addition, the language analyzer 10 attaches the derived diameter of the hole to the drawing requirement item "DEFINITION1" as attribute data of the drawing requirement item "DEFINITION1".

As described above, the language analyzer 10 determines whether the textual information indicated by the respective drawing requirement items in the tree structure 31 of the three-dimensional CAD data 22 includes textual information that is consistent with the standard data stored in the standard database 21.

Next, with regard to the textual information that is consistent with the standard data stored in the standard database 21, the language analyzer 10 derives a textual requirement (such as a diameter of a hole or a fastening method, for example) indicated by the standard data with reference to the standard database 21. In addition, the language analyzer 10 attaches the derived textual requirement to the corresponding item as attribute data.

Here, sometimes the textual requirement attached as the attribute data through the natural language analysis and a requirement that is specifically stipulated using not textual information but a numerical value, material, or the like as the respective drawing requirement items in the tree structure 31, are requirements for a same process. For example, it is assumed that, as requirements for sealing to be done at a same position, a specific numerical value and material are stipulated in the tree structure 31 and textual requirement is derived through the natural language analysis.

In such a case, the language analyzer 10 preferentially selects the requirement specifically stipulated in the tree structure 31. Next, the language analyzer 10 deletes the textual requirement attached as the attribute data through the natural language analysis. Accordingly, it is possible to prevent overlapping of different requirements of the same type at the same position.

The output module 11 outputs the analysis result (textual requirement) of the natural language analysis conducted by the language analyzer 10, as textual analysis result data. Specifically, the output module 11 may cause the storage device 5 to store the textual analysis result data in a predetermined format, or may cause the display device 7 to display the textual analysis result data.

FIG. 6 is a diagram for describing the textual analysis result data. As illustrated in FIG. 6, the textual analysis result data indicates analysis numbers, hierarchies, items, and analysis results (textual requirements). The analysis numbers indicate analysis results obtained through the natural language analysis conducted by the language analyzer 10, by using serial numbers.

The hierarchies indicate hierarchies of drawing requirement items obtained through the natural language analysis. The items indicate the drawing requirement items obtained through the natural language analysis. The textual requirements indicate analysis results (textual requirements) of the natural language analysis.

For example, as an analysis result (textual requirement) of the natural language analysis, the analysis number "1" describes "diameter 10" indicating that the diameter is 10 mm, with regard to the drawing requirement item "DEFINITION 1" in a hierarchy "3". The textual analysis result data describes all the analysis results of the natural language analysis.

Accordingly, by referring to the textual analysis result data, it is not necessary for workers in all the departments to check the tree structure 31 of the three-dimensional CAD data 22. Therefore, it is possible to improve working efficiency. In addition, in a quality management department, it is possible to use the raw textual analysis result data as a quality record.

Therefore, it is possible to simplify the work. In addition, it is possible for the departments to share the textual analysis result data. Therefore, it is possible to reduce overlapping of work between the departments such as reconfirmation or the like. In addition, it is possible for the analysis device 1 to reduce working errors made by workers.

### Language comparison process

When the language comparison process is selected and two pieces of the three-dimensional CAD data 22 are selected as comparison targets via the input interface 6, the language analyzer 10 first conducts the above-described natural language analysis on the two selected pieces of three-dimensional CAD data 22.

In addition, the language analyzer 10 extracts textual information that is item names of respective items of the tree structure 31. Note that, for example, three-dimensional CAD data 22 before correction and three-dimensional CAD data 22 after the correction are selected as the two pieces of three-dimensional CAD data 22 that serve the comparison targets.

FIG. 7 is a diagram for describing images that display a comparison result in the language comparison process. The language comparison module 12 compares two pieces of analysis result data and item names. Specifically, in the case where textual requirements are different from each other with regard to the same item in the same hierarchy, the language comparison module 12 extracts the textual requirements.

In addition, in the case where item names are different from each other in the same hierarchy, the language comparison module 12 extracts the item names. Next, the output module 11 outputs the extracted textual requirements and item names as comparison results (textual comparison result data).

Specifically, the output module 11 causes the display device 7 to display the textual comparison result data in addition to three-dimensional CAD images based on the three-dimensional CAD data 22. Note that, the output module 11 may cause the storage device 5 to store the textual comparison result data in a predetermined format.

The output module 11 decompresses the two pieces of three-dimensional CAD data 22 in the three-dimensional CAD software 20, and causes the display device 7 to display three-dimensional CAD images 100 and 101 based on the two pieces of three-dimensional CAD data 22 as illustrated in FIG. 7.

Note that, the three-dimensional CAD image 100 on the left side of FIG. 7 is an image based on the three-dimensional CAD data 22 illustrated in FIG. 4. On the other hand, the three-dimensional CAD image 101 on the right side of FIG. 7 is an image obtained by correcting (changing) a portion of the three-dimensional CAD data 22 illustrated in FIG. 4.

In addition, the output module 11 causes the display device 7 to display textual comparison result data 102 in addition to the three-dimensional CAD images 100 and 101. The textual comparison result data 102 indicates analysis numbers, hierarchies, items, and comparison results. For example, the textual comparison result data 102 indicates that a textual requirement is changed from "diameter 10" to "diameter 8" with regard to the fastening condition item "DEFINITION 1" in the hierarchy "3".

Next, when a worker uses the input interface 6 and selects any of the comparison results indicated by the textual comparison result data 102, the output module 11 highlights and displays an item corresponding to the selected comparison result in the tree structure 31. Accordingly, it is possible for the worker to immediately find the changed item, and it is possible to improve working efficiency. In addition, it is possible for the analysis device 1 to reduce working errors made by workers.

### Model comparison process

When the model comparison process is selected and two pieces of the three-dimensional CAD data 22 are selected as comparison targets via the input interface 6, the model analyzer 13 first analyzes the three-dimensional models 30 of the two selected pieces of three-dimensional CAD data 22.

Specifically, the model analyzer 13 analyzes model requirements such as shapes, sizes, positions of centers of gravity, areas, volumes, and directions of assemblies, parts, and drawing requirement items with regard to the two selected pieces of three-dimensional CAD data 22, and outputs analysis results (model requirements) as model analysis result data.

In addition, the model analyzer 13 attaches attribute data obtained through an analysis conducted by the language analyzer 10 to the assemblies, parts, and drawing requirement items in the three-dimensional models 30, and stores them in the model analysis result data.

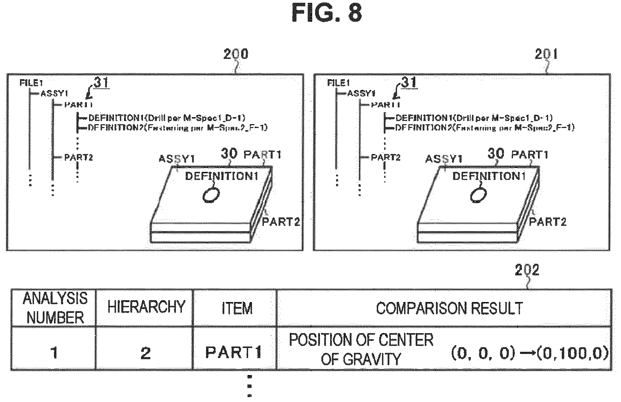

FIG. 8 is a diagram for describing images that display a comparison result in the model comparison process. The model comparison module 14 compares two pieces of the model analysis result data. Here, when a worker uses the input interface 6 and selects confirmation intensity and a hierarchy to be compared, the model comparison module 14 compares the two pieces of model analysis result data in the model analysis process on the basis of the selected confirmation intensity and mode.

The confirmation intensity indicates up to which decimal place the pieces of model analysis result data are compared. For example, the confirmation intensity includes 5 stages. In the confirmation intensity "I", the pieces of model analysis result data are compared up to one decimal place. As the confirmation intensity increases, the decimal place to be compared is incremented. The confirmation intensity is used for classifying ambiguity into levels, such that the confirmation intensity indicates a level of intensity at which pieces of data are consistent with or different from each other.

Next, the model comparison module 14 refers to the model analysis result data with regard to the assemblies, parts, and drawing requirement items in the selected hierarchy, and determines whether they are consistent with each other up to a certain number of digits corresponding to the selected confirmation intensity. Next, the model comparison module 14 extracts model requirements that are different from each other up to the number of digits corresponding to the selected confirmation intensity. Subsequently, the output module 11 outputs the extracted model requirements as comparison results (model comparison result data).

Specifically, the output module 11 causes the display device 7 to display the model comparison result data in addition to three-dimensional CAD images based on the three-dimensional CAD data 22. Note that, the output module 11 may cause the storage device 5 to store the model comparison result data in a predetermined format.

The output module 11 decompresses the two pieces of three-dimensional CAD data 22 in the three-dimensional CAD software 20, and causes the display device 7 to display three-dimensional CAD images 200 and 201 based on the two pieces of three-dimensional CAD data 22 as illustrated in FIG. 8.

Note that, the three-dimensional CAD image 200 on the left side of FIG. 8 is an image based on the three-dimensional CAD data 22 illustrated in FIG. 4. On the other hand, the three-dimensional CAD image 201 on the right side of FIG. 8 is an image obtained by correcting (changing) a portion of the three-dimensional CAD data 22 illustrated in FIG. 4.

In addition, the output module 11 causes the display device 7 to display model comparison result data 202 in addition to the three-dimensional CAD images 200 and 201. The model comparison result data 202 indicates analysis numbers, hierarchies, items, and comparison results. For example, as a comparison result, the model comparison result data 202 indicates that a position of a center of gravity is changed from "0,0,0" to "0,100,0" with regard to the part "PART1" in the hierarchy "2" as illustrated in FIG. 8.

When a worker uses the input interface 6 and selects any of the comparison results indicated by the model comparison result data 202, the output module 11 highlights and displays an assembly, part, or drawing requirement item corresponding to the selected comparison result in whole pictures of the three-dimensional models 30, or displays only the selected comparison result.

Accordingly, it is possible for the worker to immediately find the changed assembly, part, or drawing requirement item, and it is possible to improve working efficiency. In addition, it is possible for the analysis device 1 to reduce working errors made by workers.

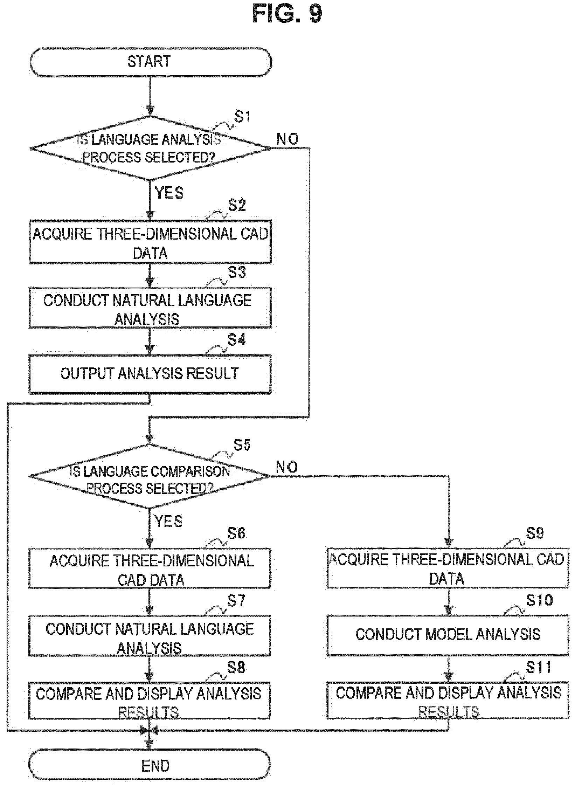

FIG. 9 is a flowchart illustrating a flow of the analysis process. As illustrated in FIG. 9, the CPU 2 determines whether the language analysis process is selected (Step S1). As a result, when the language analysis process is selected (YES in Step S1) and the three-dimensional CAD data 22 is selected as a target of the process via the input interface 6, the language analyzer 10 acquires the selected three-dimensional CAD data 22 (Step S2) and decompresses it in the RAM 4 via the three-dimensional CAD software 20.

Next, the language analyzer 10 extracts textual information of respective drawing requirement items in the tree structure 31 of the three-dimensional CAD data 22, and conducts the natural language analysis on the textual information with reference to corresponding standard data on the basis of the extracted textual information and the three-dimensional model 30 (Step S3).

Subsequently, the output module 11 outputs an analysis result (textual requirement) of the natural language analysis as textual comparison result data (Step S4), and ends the analysis process.

On the other hand, in a case where the language analysis process is not selected (No in Step S1), the CPU 2 determines whether the language comparison process is selected (Step S5). As a result, when the language comparison process is selected (YES in Step S5) and two pieces of the three-dimensional CAD data 22 are selected as targets of the process via the input interface 6, the language analyzer 10 acquires the selected three-dimensional CAD data 22 (Step S6) and decompresses it in the RAM 4 via the three-dimensional CAD software 20.

Next, the language analyzer 10 extracts textual information of respective drawing requirement items in the tree structure 31 of the two pieces of the three-dimensional CAD data 22, and conducts the natural language analysis on the textual information with reference to corresponding standard data on the basis of the extracted textual information and the three-dimensional model 30 (Step S7). In addition, the language analyzer 10 extracts textual information of item names of the tree structures 31 with regard to the two pieces of the three-dimensional CAD data 22.

Subsequently, the language comparison module 12 compares two pieces of textual analysis result data. In the case where textual requirements or item names are different from each other in a same hierarchy, the language comparison module 12 extracts the textual requirements or the item names. The output module 11 causes the display device 7 to display the extraction result as textual comparison result data (Step S8), and ends the analysis process.

On the other hand, when the language comparison process is not selected (NO in Step S5), that is, when the model comparison process is selected and two pieces of the three-dimensional CAD data 22 are selected as targets of the process via the input interface 6, the model analyzer 13 acquires the selected three-dimensional CAD data 22 (Step S9), and decompresses it in the RAM 4 via the three-dimensional CAD software 20.

Next, the model analyzer 13 analyzes model requirements with regard to the two selected pieces of three-dimensional CAD data 22, attaches attribute data analyzed by the language analyzer 10, and outputs them as model analysis result data (Step S10).

Subsequently, the model comparison module 14 compares the model analysis result data on the basis of a hierarchy or confirmation intensity selected by a worker, the output module 11 causes the display device 7 to display model requirements that are different from each other as model comparison result data (Step S11), and the analysis process ends.

Although the preferred embodiments of the invention have been described in detail with reference to the appended drawings, the invention is not limited thereto. It is obvious to those skilled in the art that various modifications or variations are possible insofar as they are within the technical scope of the appended claims or the equivalents thereof. It should be understood that such modifications or variations are also within the technical scope of the invention.

For example, in the above described embodiments, the three-dimensional CAD data 22 is used as drawing data. However, the drawing data may be two-dimensional CAD data.

In addition, in the above-described embodiments, the language analysis process, the language comparison process, and the model comparison process are performed. However, it is possible to perform any one or two of the language analysis process, the language comparison process, and the model comparison process.

In addition, in the above-described embodiments, the textual analysis result data output in the language analysis process is used as the quality records. However, as the quality records, it is also possible to use a combination of the textual analysis result data output in the language analysis process and the model analysis result data output from the model analyzer 13.

In addition, it is also possible for the analysis device 1 according to the above-described embodiments to compare the output textual analysis result data with dimensions or the like of an actually manufactured part, and determine whether they are consistent with each other.

In addition, in the language comparison process according to the above-described embodiments, it is also possible for a worker to select hierarchies, positions, directions, or the like to be compared, and compare only the selected hierarchies, positions, directions, or the like.

As described above, according to the invention, it is possible to improve working efficiency.

### List of Reference Signs

- 1: Analysis device
- 2: Central processing unit (CPU)
- 3: Read only memory (ROM)
- 4: Random access memory (RAM)
- 5: Storage device
- 6: Input/Output interface (Input I/O)
- 7: Display device
- 8: Communication device
- 9: Bus
- 10: Language analyzer
- 11: Output module
- 11a: Known standard data
- 11b: Manufacturer standard data
- 12: Language comparison module
- 13: Model analyzer
- 14: Model comparison module
- 20: Computer aided design (CAD) software
- 21: Standard database
- 22: CAD data
- 30: Three-dimensional model
- 31: Tree structure
- 100: CAD image
- 101: CAD image
- 102: Comparison result data
- 200: CAD image
- 201: CAD image
- 202: Comparison result data

## Claims

1. An analysis device (1) comprising:
a language analyzer (10) configured to conduct a natural language analysis on a textual information in a drawing data with reference to a known standard data to derive textual requirements indicated by the textual information; and
an output module (11) configured to output the textual requirements analyzed by the language analyzer (10).

2. The analysis device (1) according to claim 1, further comprising
a language comparison module (12) configured to compare analysis results of the natural language analysis conducted on pieces of the drawing data, for the respective textual requirements,
wherein the language analyzer (10) is configured to conduct the natural language analysis on the pieces of the drawing data.

3. The analysis device (1) according to claim 2, wherein,
in a case where the corresponding textual requirements in the pieces of the drawing data are different from each other, the output module (11) is configured to output the different textual requirements.

4. The analysis device (1) according to any one of claims 1 to 3, comprising:
a model analyzer (13) configured to analyze a model of the drawing data and derive model requirements; and
a model comparison module 814) configured to compare the model requirements derived by the model analyzer (13) with regard to the pieces of the drawing data, on a basis of a confirmation intensity selected by a worker.

5. The analysis device (1) according to claim 4,
wherein, in a case where the corresponding model requirements in the pieces of the drawing data are different from each other, the output module (11) is configured to output the different model requirements.
